# EUROPEAN PATENT APPLICATION

(11) **EP 3 567 635 A1**
(43) Date of publication of application: **13.11.2019**
(21) Application number: 18186875.3
(22) Date of filing: 01.08.2018
(51) Int. Cl.: H01L 31/0216, H01L 31/048, G02B 5/28

(54) **SOLAR MODULE**

(30) Priority: 08.05.2018 CN 201820679745 U; 04.07.2018 WO PCT/CN2018/094444
(71) Applicant: Beijing Hanergy Solar Power Investment Co., Ltd., 101499 Beijing (CN)
(72) Inventor: WU, Zhenyu, Beijing, Beijing 101499 (CN); TAO, Lisong, Beijing, Beijing 101499 (CN); WAN, Junpeng, Beijing, Beijing 101499 (CN); YAN, Yi, Beijing, Beijing 101499 (CN); YANG, Shizhong, Beijing, Beijing 101499 (CN); FANG, Zhenlei, Beijing, Beijing 101499 (CN)
(74) Representative: D'Halleweyn, Nele Veerle Trees Gertrudis

(57) **Abstract**

A solar module is provided, comprising a front plate, a film, a solar cell and a back plate which are arranged in sequence, or comprising a front plate, a film, a solar cell, a film and a back plate which are arranged in sequence, wherein the front plate is a colored light-transmitting front plate.

## Description

### Technical Field

The present disclosure relates to, but is not limited to, the technical field of solar energy, in particular to a solar module.

### Background

At present, the solar module used in buildings is mainly black, which is not beautiful enough. In order to adapt to the more demanding demands of the photovoltaic market, while continuously improving the conversion efficiency of the module, the appearance thereof should be more humanized and conform to the needs of the environment. Especially, the integration of photovoltaic products with buildings and environment is more urgent to the aesthetic demand. As for photovoltaic products as building materials, people hope to show individualities of a building.

### Summary

The following is an overview of the subject matter described in detail herein. This summary is not intended to limit the protection scope of the claims.

At least one embodiment of the present disclosure provides a solar module, which includes a front plate, a film, a solar cell and a back plate which are arranged in sequence, or includes a front plate, a film, a solar cell, a film and a back plate which are arranged in sequence, wherein the front plate is a colored light-transmitting front plate.

In an embodiment of the present disclosure, the solar module can be a planar module, a special-shaped module, or can be a combination of a planar module and a special-shaped module.

In an embodiment of the present disclosure, the special-shaped module can be a folded surface module or a curved surface module, or the solar module can be a combination of special-shaped modules of at least two different shapes.

In an embodiment of the present disclosure, the colored light-transmitting front plate can be a colored light-transmitting coated plate or a colored light-transmitting raw sheet plate, and the colored light-transmitting coated plate can include a light-transmitting substrate and a film layer disposed on the light-transmitting substrate.

In an embodiment of the present disclosure, when the colored light-transmitting front plate is a colored light-transmitting coated plate, the film layer can be a full dielectric film, and the film layer can include at least one high refractive index material film, and the refractive index of the high refractive index material film can be higher than that of the light-transmitting substrate.

In an embodiment of the present disclosure, the refractive index of the high refractive index material film at a wavelength of 550 nm can be in the range of 1.92 to 2.60.

In an embodiment of the present disclosure, the high refractive index material film can include a lanthanum titanate film, a titanium dioxide film, a trititanium pentoxide film, a niobium pentoxide film, a tantalum pentoxide film, a zirconium dioxide film, or a composite film formed by at least two of these films.

In an embodiment of the present disclosure, the film layer can further include at least one layer of low refractive index material film, the refractive index of the low refractive index material film being lower than that of the light-transmitting substrate;
when the film layer includes multiple layers of the high refractive index material film and multiple layers of the low refractive index material film, the multiple layers of the high refractive index material film and the multiple layers of the low refractive index material film can be alternately packed on the light-transmitting substrate.

In an embodiment of the present disclosure, the film layer can include two layers of the high refractive index material film and two layers of the low refractive index material film, two layers of the high refractive index material film and two layers of the low refractive index material film are alternately packed on one side of the light-transmitting substrate, and the light-transmitting substrate is adjacent to the high refractive index material film.

In an embodiment of the present disclosure, the film layer can include three layers of the high refractive index material film and two layers of the low refractive index material film, three layers of the high refractive index material film and two layers of the low refractive index material film are alternately packed on one side of the light-transmitting substrate, and the light-transmitting substrate is adjacent to the high refractive index material film.

In an embodiment of the present disclosure, the film layer can include three layers of the high refractive index material film and three layers of the low refractive index material film, three layers of the high refractive index material film and three layers of the low refractive index material film are alternately packed on one side of the light-transmitting substrate, and the light-transmitting substrate is adjacent to the high refractive index material film.

In an embodiment of the present disclosure, the refractive index of the low refractive index material film at a wavelength of 550 nm can be in the range of 1.35 to 1.50.

In an embodiment of the present disclosure, the low refractive index material film can include a silicon dioxide film, a magnesium fluoride film, or a composite film of a silicon dioxide film and a magnesium fluoride film.

In an embodiment of the present disclosure, the light-transmitting substrate can be a glass substrate or a light-transmitting polymer material substrate.

In an embodiment of the present disclosure, the film layer can be a colored glazed film layer.

In an embodiment of the present disclosure, the color of the colored light-transmitting front plate can be blue, purple, golden, yellow, red, pottery clay color, gray, orange or green.

In an embodiment of the present disclosure, the back plate can be a colored light-transmitting coated plate or a colored light-transmitting raw sheet plate.

In an embodiment of the present disclosure, the film can be polyvinyl butyral (PVB) flexible film or ethylene vinyl acetate (EVA) flexible film.

In an embodiment of the present disclosure, the solar cell includes a crystalline silicon thin film solar cell, an amorphous silicon thin film solar cell, a gallium arsenide thin film solar cell, a copper indium gallium selenium thin film solar cell, a copper indium selenium thin film solar cell, a cadmium telluride thin film solar cell, or an organic polymer thin film solar cell.

Other features and advantages of the present disclosure will be set forth in the following description and, in part, will become apparent from the description, or can be learned by carrying out the present disclosure. The objects and other advantages of the present disclosure can be realized and attained by the structure particularly pointed out in the description, claims, and drawings.

### Brief Description of Drawings

The accompanying drawings are used to provide a further understanding of the technical solutions of the present disclosure and form a part of the specification, and together with the embodiments of the present disclosure, serve to explain the technical solution of the present disclosure and do not constitute a limitation on the technical solution of the present disclosure.
FIG. 1 is a graph of transmissivity of a colored light-transmitting coated plate according to an embodiment of the present disclosure;
FIG. 2 is a graph of transmissivity of a colored light-transmitting coated plate according to another embodiment of the present disclosure;
FIG. 3 is a graph of transmissivity of a colored light-transmitting coated plate according to yet another embodiment of the present disclosure;
FIG. 4 is a graph of transmissivity of a colored light-transmitting coated plate according to still another embodiment of the present disclosure;
FIG. 5 is a schematic structural diagram of a solar module according to an embodiment of the present disclosure;
FIG. 6 is a schematic structural diagram of a solar module according to another embodiment of the present disclosure;
FIG. 7 is a schematic structural diagram of a solar module according to yet another embodiment of the present disclosure;
FIG. 8 is a schematic structural diagram of a solar module according to still another embodiment of the present disclosure.

### Detailed Description of Embodiments

Embodiments of the present disclosure will be described in detail below with reference to the accompanying drawings in order to make the objects, technical solutions and advantages of the present disclosure more clearly understood. It should be noted that, if without conflict, the embodiments and the features in the embodiments of the present disclosure can be combined with each other arbitrarily.

Embodiments of the present disclosure provide a solar module with good power generation effect and good color effect.

An embodiment of the present disclosure provides a solar module, which includes a front plate, a film, a solar cell and a back plate which are arranged in sequence, or includes a front plate, a film, a solar cell, a film and a back plate which are arranged in sequence, wherein the front plate is a colored light-transmitting front plate.

The solar module can be a planar module, or a special-shaped module, or a combination of a planar module and a special-shaped module. Therefore, the shape of the matching solar module can be selected according to the shape of a building.

The special-shaped module can be a combination of any one or more of a folded surface module, a curved surface module, and a special-shaped module in other shapes.

The folded surface module can be one type of folded surface module or a combination of more types of folded surface modules.

The curved surface module can be one type of curved surface module or a combination of more types of curved surface modules.

The colored light-transmitting front plate can be a colored light-transmitting coated plate or a colored light-transmitting raw sheet plate, and the colored light-transmitting coated plate includes a light-transmitting substrate and a film layer arranged on the light-transmitting substrate.

The film layer can be a full dielectric film, and the film layer can include at least one high refractive index material film, and the refractive index of the high refractive index material film is higher than that of the light-transmitting substrate. The full dielectric film can display color under the irradiation of sunlight, and the film system can be designed for the full dielectric film as needed so as to display the desired color. In addition, the transmissivity of the full dielectric film is high in the infrared band, so that the average transmissivity in the power generation wavelength range of the solar module, especially in the 380 nm to 1100 nm band, is greatly increased, which can significantly improve the power generation efficiency of the solar module. In addition, when the full dielectric film is selected as the film layer on the colored light-transmitting front plate instead of the metal film layer, the problem of oxidation of the metal film layer is avoided, and the metal protective layer no longer needs to be arranged, thus saving the cost.

The high refractive index material film can be formed of a material having a refractive index of 1.92 to 2.60 at a wavelength of 550 nm. The selection of this high refractive index material film can improve the average transmissivity of the colored light-transmitting front plate in the power generation wavelength range of the solar module to a greater extent, thus improving the power generation effect of the solar module.

The high refractive index material film can be selected from a lanthanum titanate film, a titanium dioxide film, a trititanium pentoxide film, a niobium pentoxide film, a tantalum pentoxide film, a zirconium dioxide film, or a composite film formed by at least two of these films. The selection of this high refractive index material film can improve the average transmissivity of the colored light-transmitting front plate in the power generation wavelength range of the solar module to a greater extent, thus improving the power generation effect of the solar module. When the high refractive index material film is selected from any one of the lanthanum titanate film, the titanium dioxide film, the trititanium pentoxide film, the niobium pentoxide film, the tantalum pentoxide film, and the zirconium dioxide film, the solar module of the present disclosure has better power generation effect and simpler production process.

The full dielectric film of the solar module of the embodiments of the present disclosure can also include at least one layer of low refractive index material film, the refractive index of the low refractive index material film is lower than that of the light-transmitting substrate, and the at least one layer of high refractive index material film and the at least one layer of low refractive index material film are alternately arranged on the light-transmitting substrate. When comprising a low refractive index material film, the full dielectric film can obtain a more diversified film system design structure, thus ensuring that the solar module can obtain more colors on the premise of having good power generation effect.

The low refractive index material film can be formed of a material having a refractive index of 1.35 to 1.50 at a wavelength of 550 nm. The selection of this low refractive index material film can improve the average transmissivity of the colored light-transmitting front plate in the power generation wavelength range of the solar module to a greater extent, thus improving the power generation effect of the solar module.

The low refractive index material film is selected from a silicon dioxide film, a magnesium fluoride film, or a composite film of a silicon dioxide film and a magnesium fluoride film. The selection of this low refractive index material film can improve the average transmissivity of the colored light-transmitting front plate in the power generation wavelength range band of the solar module to a greater extent, thus improving the power generation effect of the solar module. When the low refractive index material film is selected from any one of the silicon dioxide film and the magnesium fluoride film, the solar module of the present disclosure has better power generation effect and simpler production process.

The colored light-transmitting coated plate can include a light-transmitting substrate and a high refractive index material film, which are arranged in sequence.

The colored light-transmitting coated plate can include a light-transmitting substrate, a high refractive index material film, a low refractive index material film, a high refractive index material film, and a low refractive index material film, which are arranged in sequence.

The colored light-transmitting coated plate can include a light-transmitting substrate, a high refractive index material film, a low refractive index material film, a high refractive index material film, a low refractive index material film, and a high refractive index material film, which are arranged in sequence.

The colored light-transmitting coated plate can include a light-transmitting substrate, a high refractive index material film, a low refractive index material film, a high refractive index material film, a low refractive index material film, a high refractive index material film, and a low refractive index material film, which are arranged in sequence.

The colored light-transmitting coated plate can include a light-transmitting substrate, a low refractive index material film, and a high refractive index material film, which are arranged in sequence.

The light-transmitting substrate can be a glass substrate or a light-transmitting polymer material substrate; the glass substrate can be ultra-white float glass, ordinary float glass, body colored glass or optical glass, etc.; the light-transmitting polymer material substrate can be a light-transmitting resin substrate such as a light-transmitting polycarbonate (PC) substrate or a light-transmitting polymethyl methacrylate (PMMA) substrate, etc.; the thickness of the glass substrate can be 3.2 mm to 8 mm. Therefore, the appropriate type of light-transmitting substrate and the thickness thereof can be selected according to different application occasions and requirements, such as flexibility, light transmissivity and the like.

The film layer can also be a colored glazed film layer. Therefore, a colored film layer can be formed on the light-transmitting substrate by selecting colors as needed and colored glazing.

The back plate can be a colored light-transmitting coated plate or a colored light-transmitting raw sheet plate. The back plate has a decorative effect so that the appearance of the solar module of the present disclosure is more beautiful.

Depending on different designs of the film layer, the color of the colored light-transmitting front plate can be blue, purple, golden, yellow, red, pottery clay color, gray, orange or green. On the premise of ensuring high average transmissivity in the power generation wavelength range of the solar module, the solar module of the present disclosure can be made into different colors as needed, meeting the demand for rich and various colors, and being more beautiful after being combined with buildings.

The following is a list of some embodiments of colored light-transmitting coated plates comprising full dielectric films, wherein the light-transmitting substrate used is ultra-white float glass with a thickness of 3.2 mm to 8 mm, and the colored light-transmitting coated plate in this case is a colored coated glass. Wherein Ti₃O₅ (1) represents that the first layer on the light-transmitting substrate is a high refractive index material, Ti₃O₅, SiO₂ (2) represents that the second layer is a low refractive index material, SiO₂, and so on. Among them, taking "Air/light-transmitting substrate/Ti₃O₅ (1)/SiO₂ (2)/Ti₃O₅ (3)/SiO₂ (4)/Air" as an example, it means that the coated plate only includes a light-transmitting substrate, a Ti₃O₅ film, an SiO₂ film, a Ti₃O₅ film, and an SiO₂ film, which are packed in sequence, and "Air/light-transmitting substrate" means that the side of the light-transmitting substrate which is not in contact with the Ti₃O₅ film is in direct contact with air, and so on.

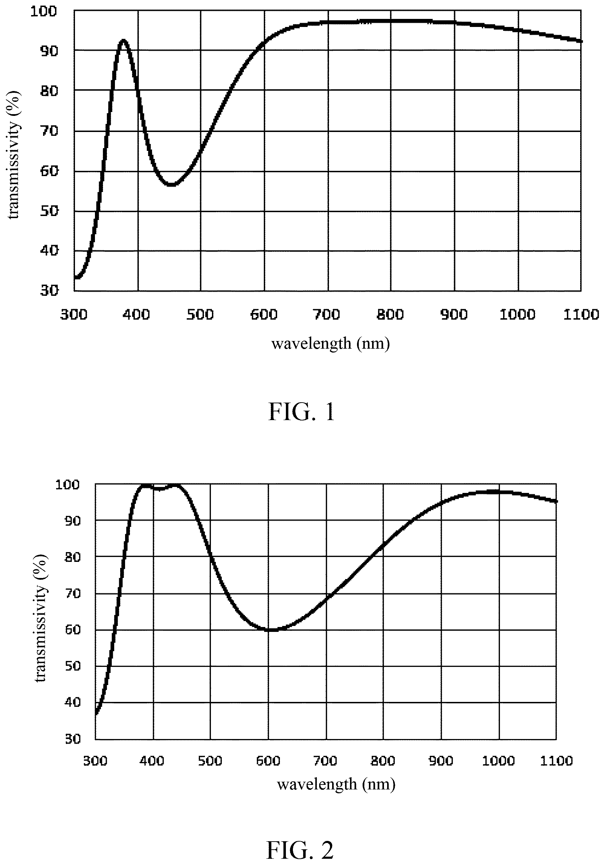

An embodiment of the present disclosure provides a blue coated glass, the transmissivity curve of which is shown in FIG. 1. The blue coated glass can include four layers of full dielectric film, the film system design structure of which can be in the following forms:
a. Air/light-transmitting substrate/Ti₃O₅ (1)/SiO₂ (2)/Ti₃O₅ (3)/SiO₂ (4)/Air, wherein the thickness of Ti₃O₅ (1) is 33.48 nm±20 nm, the thickness of SiO₂ (2) is 51.96 nm±20 nm, the thickness of Ti₃O₅ (3) is 82.86 nm±20 nm, and the thickness of SiO₂ (4) is 117.36 nm±20 nm; or
b. Air/light-transmitting substrate/Ta₂O₅ (1)/SiO₂ (2)/Ta₂O₅ (3)/SiO₂ (4)/Air, wherein the thickness of Ta₂O₅ (1) is 32.81 nm±20 nm, the thickness of SiO₂ (2) is 55.97 nm±20 nm, the thickness of Ta₂O₅ (3) is 78.81 nm±20 nm, and the thickness of SiO₂ (4) is 117.11 nm±20 nm; or
c. Air/light-transmitting substrate/Nb₂O₅ (1)/SiO₂ (2)/Nb₂O₅ (3)/SiO₂ (4)/Air, wherein the thickness of Nb₂O₅ (1) is 33.41 nm±20 nm, the thickness of SiO₂ (2) is 51.96 nm±20 nm, the thickness of Nb₂O₅ (3) is 82.68 nm 20±nm, and the thickness of SiO₂ (4) is 117.36 nm±20 nm.

Another embodiment of the present disclosure provides a golden coated glass, the transmissivity curve of which is shown in FIG. 2. The golden coated glass can include five layers of full dielectric film, the film system design structure of which can be in the following forms:
a. Air/light-transmitting substrate/Ti₃O₅ (1)/SiO₂ (2)/Ti₃O₅ (3)/SiO₂ (4)/Ti₃O₅ (5)/Air, wherein the thickness of Ti₃O₅ (1) is 91.66 nm±20 nm, the thickness of SiO₂ (2) is 35.17 nm±20 nm, the thickness of Ti₃O₅ (3) is 66.32 nm±20 nm, the thickness of SiO₂ (4) is 17.03 nm±20 nm, and the thickness of Ti₃O₅ (5) is 15.07 nm±20 nm; or
b. Air/light-transmitting substrate/Ta₂O₅ (1)/SiO₂ (2)/Ta₂O₅ (3)/SiO₂ (4)/Ta₂O₅ (5)/Air, wherein the thickness of Ta₂O₅ (1) is 94.35 nm±20 nm, the thickness of SiO₂ (2) is 44.22 nm±20 nm, the thickness of Ta₂O₅ (3) is 63.02 nm±20 nm, the thickness of SiO₂ (4) is 15.74 nm±20 nm, and the thickness of Ta₂O₅ (5) is 19.76 nm±20 nm; or
c. Air/light-transmitting substrate/Nb₂O₅ (1)/SiO₂ (2)/Nb₂O₅ (3)/SiO₂ (4)/Nb₂O₅ (5)/Air, wherein the thickness of Nb₂O₅ (1) is 91.46 nm±20 nm, the thickness of SiO₂ (2) is 35.31 nm±20 nm, the thickness of Nb₂O₅ (3) is 58.56 nm±20 nm, the thickness of SiO₂ (4) is 18.45 nm±20 nm, and the thickness of Nb₂O₅ (5) is 17.71 nm±20 nm.

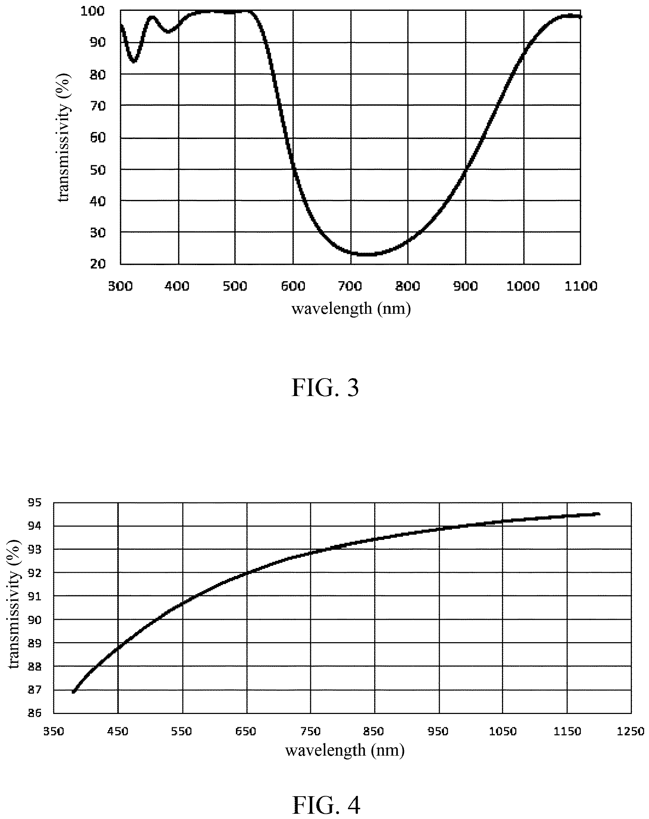

Yet another embodiment of the present disclosure provides a red coated glass, the transmissivity curve of which is shown in FIG. 3. The red coated glass can include six layers of full dielectric film, the film system design structure of which can be in the following forms:
a. Air/light-transmitting substrate/Ti₃O₅ (1)/SiO₂ (2)[Ti₃O₅ (3)/SiO₂ (4)/Ti₃O₅ (5)/SiO₂ (6)/Air, wherein the thickness of Ti₃O₅ (1) is 86.16 nm±20 nm, the thickness of SiO₂ (2) is 120.43 nm±20 nm, the thickness of Ti₃O₅ (3) is 72.95 nm±20 nm, the thickness of SiO₂ (4) is 125.76 nm±20 nm, the thickness of Ti₃O₅ (5) is 68.70 nm±20 nm, and the thickness of SiO₂ (6) is 63.09 nm±20 nm; or
b. Air/light-transmitting substrate/Ta₂O₅ (1)/SiO₂ (2)/Ta₂O₅ (3)/SiO₂ (4)/Ta₂O₅ (5)/SiO₂ (6)/Air, wherein the thickness of Ta₂O₅ (1) is 90.83 nm±20 nm, the thickness of SiO₂ (2) is 117.22 nm±20 nm, the thickness of Ta₂O₅ (3) is 76.76 nm±20 nm, the thickness of SiO₂ (4) is 123.06 nm±20 nm, the thickness of Ta₂O₅ (5) is 69.84 nm±20 nm, and the thickness of SiO₂ (6) is 61.50 nm±20 nm; or
c. Air/light-transmitting substrate/Nb₂O₅ (1)/SiO₂ (2)/Nb₂O₅ (3)/SiO₂ (4)/Nb₂O₅ (5)/SiO₂ (6)/Air, wherein the thickness of Nb₂O₅ (1) is 85.26 nm±20 nm, the thickness of SiO₂ (2) is 120.06 nm±20 nm, the thickness of Nb₂O₅ (3) is 72.44 nm±20 nm, the thickness of SiO₂ (4) is 125.56 nm±20 nm, the thickness of Nb₂O₅ (5) is 68.66 nm±20 nm, and the thickness of SiO₂ (6) is 63.22 nm±20 nm.

Still another embodiment of the present disclosure provides a gray coated glass, the transmissivity curve of which is shown in FIG. 4. The gray coated glass can include one layer of full dielectric film, the film system design structure of which can be in the following forms:
a. Air/light-transmitting substrate/Ti₃O₅ (1)/Air, wherein the thickness of Ti₃O₅ (1) is 23 nm±20 nm; or
b. Air/light-transmitting substrate/Ta₂O₅ (1)/Air, wherein the thickness of Ta₂O₅ (1) is 30 nm±20 nm; or
c. Air/light-transmitting substrate/Nb₂O₅ (1)/Air, wherein the thickness of Nb₂O₅ (1) is 22.66 nm±20 nm.

As can be seen from FIGS. 1-4, although the colored light-transmitting coated plate of the embodiment of the present disclosure has a low transmissivity in the visible light region, it has a high transmissivity in the infrared light region, especially a high average transmissivity in the range of 380 nm to 1100 nm band. When used as a colored light-transmitting front plate of the solar module, the colored light-transmitting coated plate will achieve better power generation effect.

In addition, it can be understood that colored light-transmitting front plates of the same color can also be produced with the same high refractive index material and low refractive index material, by increasing or decreasing the number of the layers of the coated layer and adjusting the thickness of each layer of film, for example, increasing or decreasing the thickness of the film. Moreover, the spectra of the colored light-transmitting front plates of the same color prepared by different film system design structures are almost the same. However, when designing the film system, the film with smaller number of layers should be used as far as possible so as to reduce the cost.

The following is a list of some embodiments of solar modules.

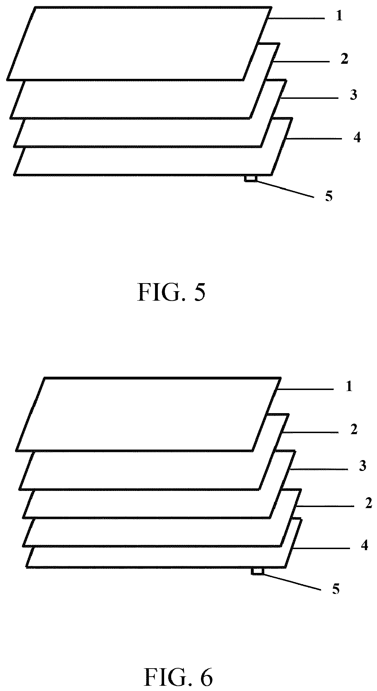

As shown in FIG. 5, in one embodiment, the solar module includes a colored light-transmitting front plate 1, a film 2, a solar cell 3 and a back plate 4 which are arranged in sequence. Below or beside the back plate 4 is arranged with a junction box 5 which is electrically connected to the solar cell 3. Any colored light-transmitting coated plate shown in FIGS. 1 - 4 can be used for the colored light-transmitting front plate 1. The solar module of this embodiment is a planar module.

As shown in FIG. 6, in another embodiment, the solar module can include a colored light-transmitting front plate 1, a film 2, a solar cell 3, a film 2 and a back plate 4 which are arranged in sequence. Below or beside the back plate 4 is arranged with a junction box 5 which is electrically connected to the solar cell 3. A colored light-transmitting raw sheet plate or a colored glazed glass comprising a colored glazed film layer can be chosen for the colored light-transmitting front plate 1. The solar module of this embodiment is a planar module.

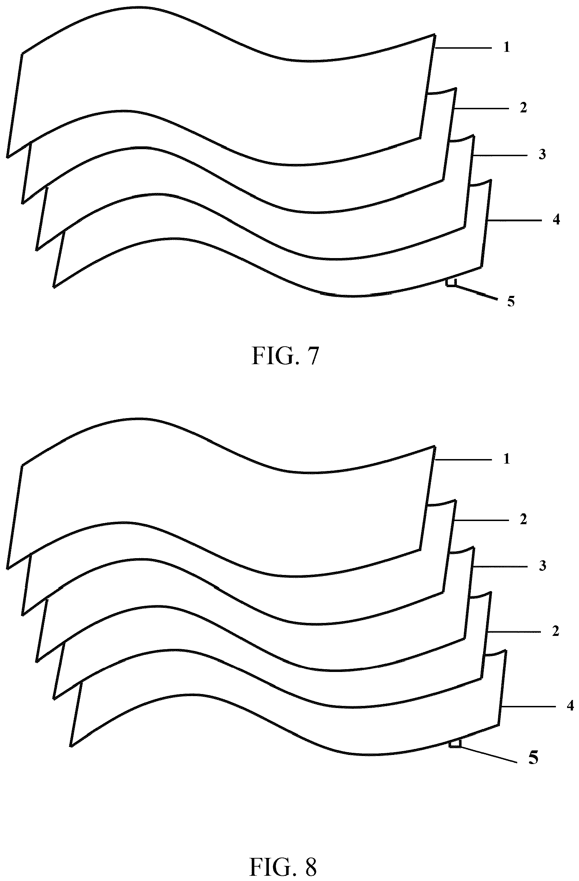

As shown in FIG. 7, in yet another embodiment, the solar module can include a colored light-transmitting front plate 1, a film 2, a solar cell 3 and a back plate 4 which are arranged in sequence. Below or beside the back plate 4 is arranged with a junction box 5 which is electrically connected to the solar cell 3. Any colored light-transmitting coated plate shown in FIGS. 1 - 4 can be used for the colored light-transmitting front plate 1. The solar module of this embodiment is a curved surface module.

As shown in FIG. 8, in still another embodiment, the solar module includes a colored light-transmitting front plate 1, a film 2, a solar cell 3, a film 2 and a back plate 4 which are arranged in sequence. Below or beside the back plate 4 is arranged with a junction box 5 which is electrically connected to the solar cell 3. Any colored light-transmitting coated plate shown in FIGS. 1-4 can be used for the colored light-transmitting front plate 1. The solar module of this embodiment is a curved surface module.

The colored light-transmitting front plates used by the solar module of the embodiments of the present disclosure have high transmissivity in the infrared band, so that the average transmissivity in the power generation wavelength range of the solar module, especially in the 380 nm to 1100 nm band, is greatly increased, and the power generation efficiency of the solar module of the embodiments of the present disclosure is significantly improved. Meanwhile, the colored light-transmitting coated plate in the solar module according to the embodiments of the present disclosure can be made into different colors as needed, meeting the demand for rich and various colors, and being more beautiful after being combined with buildings.

Moreover, when a colored light-transmitting coated plate comprising a colored glazed film layer or a full dielectric film is used as the front plate, the problem of oxidation of the metal film layer is avoided due to the absence of any metal film layer, and the metal protective layer no longer needs to be arranged, thus saving the cost.

In addition, the solar module of the embodiments of the present disclosure can be made to be planar and/or special-shaped, such as folded surface, curved surface or other special-shaped, according to the requirements of the application occasion, thus extending the scope of the application occasion.

The specific type of solar cell is not limited. In the embodiments of the present disclosure, the solar cell can be selected from a crystalline silicon thin film solar cell, an amorphous silicon thin film solar cell, a gallium arsenide thin film solar cell, a copper indium gallium selenium thin film solar cell, a copper indium selenium thin film solar cell, a cadmium telluride thin film solar cell, or an organic polymer thin film solar cell, etc.

This disclosure is illustrative of the principles of embodiments of the present disclosure, and is not making any formal or substantial limitation to the disclosure or limiting the disclosure to particular embodiments. It will be apparent to those skilled in the art that variations, changes, modifications, evolutions, and the like can be made to the elements, methods, and systems of the technical solutions of the embodiments of the present disclosure without departing from the principles, spirit, and scope of the embodiments and technical solutions of the present disclosure above. Embodiments of such variations, changes, modifications, and evolutions are all included within equivalent embodiments of the present disclosure. Although the embodiments of the present disclosure can be embodied in many different forms, what are described in detail herein are some embodiments of the disclosure. Furthermore, embodiments of the present disclosure include any possible combination of some or all of the various embodiments herein. All patents, patent applications, and other cited materials mentioned anywhere in this disclosure or in any cited patent, cited patent application, or other cited material are hereby incorporated by reference in their entirety.

The above disclosure is intended to be illustrative and not exhaustive. This description will suggest many variations and alternatives to those skilled in the art. The term "comprising" means "including, but not limited to".

A description of alternative embodiments of the present disclosure has been completed herein. Those skilled in the art will recognize other equivalents to the embodiments herein.

## Claims

1. A solar module, comprising a front plate (1), a film (2), a solar cell (3) and a back plate (3) which are arranged in sequence, or comprising a front plate (1), a film (2), a solar cell (3), a film (2) and a back plate (4) which are arranged in sequence, wherein the front plate (1) is a colored light-transmitting front plate.

2. The solar module according to claim 1, wherein the solar module is a planar module, a special-shaped module, or a combination of a planar module and a special-shaped module.

3. The solar module according to claim 2, wherein the special-shaped module is a folded surface module or a curved surface module, or the solar module is a combination of special-shaped modules of at least two different shapes.

4. The solar module according to any one of claims 1-3, wherein the colored light-transmitting front plate is a colored light-transmitting coated plate or a colored light-transmitting raw sheet plate, and the colored light-transmitting coated plate comprises a light-transmitting substrate and a film layer arranged on the light-transmitting substrate.

5. The solar module according to claim 4, wherein when the colored light-transmitting front plate is a colored light-transmitting coated plate, the film layer is a full dielectric film, and the film layer comprises at least one high refractive index material film, and the refractive index of the high refractive index material film is higher than that of the light-transmitting substrate.

6. The solar module according to claim 5, wherein
the refractive index of the high refractive index material film at a wavelength of 550 nm is in the range of 1.92 to 2.60, and/or
the high refractive index material film comprises a lanthanum titanate film, a titanium dioxide film, a trititanium pentoxide film, a niobium pentoxide film, a tantalum pentoxide film, a zirconium dioxide film, or a composite film formed by at least two of these films.

7. The solar module according to any one of claims 5-6, wherein the film layer further comprises at least one low refractive index material film, the refractive index of the low refractive index material film being lower than that of the light-transmitting substrate;
when the film layer comprises multiple layers of the high refractive index material film and multiple layers of the low refractive index material film, the multiple layers of the high refractive index material film and the multiple layers of the low refractive index material film are alternately packed on the light-transmitting substrate.

8. The solar module according to claim 7, wherein
the film layer comprises two layers of the high refractive index material film and two layers of the low refractive index material film, two layers of the high refractive index material film and two layers of the low refractive index material film are alternately packed on one side of the light-transmitting substrate, and the light-transmitting substrate is adjacent to the high refractive index material film, or
the film layer comprises three layers of the high refractive index material film and two layers of the low refractive index material film, three layers of the high refractive index material film and two layers of the low refractive index material film are alternately packed on one side of the light-transmitting substrate, and the light-transmitting substrate is adjacent to the high refractive index material film, or
the film layer comprises three layers of the high refractive index material film and three layers of the low refractive index material film, three layers of the high refractive index material film and three layers of the low refractive index material film are alternately packed on one side of the light-transmitting substrate, and the light-transmitting substrate is adjacent to the high refractive index material film.

9. The solar module according to any one of claims 7, wherein
the refractive index of the low refractive index material film at a wavelength of 550 nm is in the range of 1.35 to 1.50, and/or
the low refractive index material film comprises a silicon dioxide film, a magnesium fluoride film, or a composite film of a silicon dioxide film and a magnesium fluoride film.

10. The solar module according to any one of claims 4-9, wherein the light-transmitting substrate is a glass substrate or a light-transmitting polymer material substrate.

11. The solar module according to any one of claims 4-9, wherein the film layer is a colored glazed film layer.

12. The solar module according to any one of claims 1-11, wherein the color of the colored light-transmitting front plate is blue, purple, golden, yellow, red, pottery clay color, gray, orange or green.

13. The solar module according to any one of claims 1-12, wherein the back plate (4) is a colored light-transmitting coated plate or a colored light-transmitting raw sheet plate.

14. The solar module according to any one of claims 1-13, wherein the film (2) is polyvinyl butyral flexible film or ethylene vinyl acetate flexible film.

15. The solar module according to any one of claims 1-14, wherein the solar cell (3) comprises a crystalline silicon thin film solar cell, an amorphous silicon thin film solar cell, a gallium arsenide thin film solar cell, a copper indium gallium selenium thin film solar cell, a copper indium selenium thin film solar cell, a cadmium telluride thin film solar cell, or an organic polymer thin film solar cell.
